# EUROPEAN PATENT APPLICATION

(11) **EP 4 375 776 A1**
(43) Date of publication of application: **29.05.2024**
(21) Application number: 22846025.9
(22) Date of filing: 17.05.2022
(51) Int. Cl.: G05B 19/418, G05B 13/04

(54) **DEVICE AND METHOD FOR GENERATING TEMPLATE-BASED CRYSTALLIZATION PROCESS MODEL**

(30) Priority: 22.07.2021 KR 20210096454
(71) Applicant: CJ Cheiljedang Corporation, Seoul 04560 (KR)
(72) Inventor: HONG, Seok Bin, Seoul 04560 (KR); KIM, Jun-Woo, Seoul 04560 (KR); MOON, Sun-Joo, Seoul 04560 (KR); YUN, Jeong-Ho, Cambridge, Massachusetts 02142 (US); KIM, Wangsoo, Seoul 06236 (KR)
(74) Representative: Bates, Philip Ian
(86) International application number: PCT/KR2022/007081
(87) International publication number: WO 2023/003153

(57) **Abstract**

The present application provides method for operating a crystallization process model generating device. The method includes receiving selections of a solubility template, a particle size distribution template, a crystallization device template, a process time template, and a concentration factor template provided in a certain order, respectively, performing modeling of a crystallization process model by combining the selected templates, and when the crystallization process model is built, receiving an input of a condition for an injection liquid to perform a simulation for deriving a crystal suspension by inputting the injection liquid into the crystallization process model.

## Description

### [Technical Field]

The present invention relates to generation of a template-based crystallization process model.

### [Background Art]

With the Fourth Industrial Revolution, demands for digital-based process modeling and simulation technology are also rapidly increasing in chemical and bio industries. In general, digital process modeling uses programming languages for modeling or specialized tools for process modeling and simulation, making it difficult for general chemistry and bio basic researchers without modeling-related expertise or experience to use the same. Accordingly, since it is requested from an expert to generate digital process modeling, it costs a lot of money and time, and there are difficulties in modifying or managing the produced process model and simulation process.

In addition, modeling and simulation related to industrial equipment applied to actual industrial sites require case-specific equipment elements and expertise applied in actual industrial sites, in addition to a modeling building operation, so there is a limit to generating accurate models. For example, during a crystallization process of chemical processes, there is a solid phase with particle size distribution, and a population balance equation for the same should be simulated or a sedimentation/flotation phenomenon depending on the particle size distribution should be simulated by a geometry of crystallization equipment.

Therefore, there is a need for technology that allows basic researchers without expertise or experience to provide a crystallization process modeling and a simulation that provides various crystallization properties and process templates at low cost.

As a related prior document, Korean Patent No. 1180057 discloses "Device and method for modeling mixing phenomenon between materials."

### [Disclosure]

### [Technical Problem]

An object of the present application is to provide a device and a method for generating a template-based crystallization process model to perform a simulation by using templates built for solubility, particle size distribution, crystallization device, process time, and concentration factor to generate a crystallization process model according to a selected template.

Embodiments according to the present disclosure can be used to achieve other objects not specifically mentioned in addition to the above object.

### [Technical Solution]

A method for operating a crystallization process model generating device according to an exemplary embodiment of the present disclosure includes: receiving selections of a solubility template, a particle size distribution template, a crystallization device template, a process time template, and a concentration factor template provided in a certain order, respectively; performing modeling of a crystallization process model by combining the selected templates; and when the crystallization process model is built, receiving an input of a condition for an injection liquid to perform a simulation for deriving a crystal suspension by inputting the injection liquid into the crystallization process model.

The receiving selections may include, when a parameter value different from a default value of a parameter set for the template is input, temporarily storing the template changed with the input parameter value. The parameter may indicate one or more parameters among a solubility parameter, a nucleation rate model parameter, a crystal growth rate model parameter, an inter-compartment unit flow rate flow, a sedimentation/flotation cutoff size, a temporal temperature and concentration process condition.

The method may further include building templates for crystallization properties and crystallization process. The building templates may include: dividing constitutional unit compartments based on a geometry of a crystallization device; and building a plurality of crystallization device templates based on the crystallization device by determining whether the constitutional unit compartments are cycled.

The building templates may include building a plurality of solubility templates with which representative model material systems are matched based on a range of solubility. The model material systems of the solubility templates may be used as parameters for predicting a yield.

The building templates may include building a plurality of particle size distribution templates with which representative model material systems are matched based on a range of particle size distribution. The model material systems of the particle size distribution templates may be used as parameters for simulating a population balance equation.

The method may further include analyzing a result of the simulation so that parameters of the templates applied to the crystallization process model are optimized based on the condition for the injection solution and the crystal suspension, and providing analysis data.

A computing device according to an exemplary embodiment of the present disclosure includes: a memory comprising instructions; and at least one processor configured to generate a crystallization process model by executing the instructions. The processor is configured to: receive selections of one or more templates of a crystallization property template and a process template provided in a certain order; and perform modeling of a crystallization process model by combining the selected templates.

The processor may be configured to: receive selections of a solubility template, a particle size distribution template, a crystallization device template, a process time template, and a concentration factor template provided in a certain order, respectively; when a parameter for a specific template is input, temporarily store a template to which the input parameter is applied; and when no parameter is input, temporarily store a template to which default values for the template is applied.

The processor may be configured to receive one or more parameters among a solubility parameter, a nucleation rate model parameter, a crystal growth rate model parameter, an inter-compartment unit flow rate flow, a sedimentation/flotation cutoff size, a temporal temperature and concentration process condition.

The processor may be configured to: when the crystallization process model is built, receive an input of a condition for an injection liquid; and perform a simulation for deriving a crystal suspension by inputting the injection liquid into a crystallization process model.

The processor may be configured, when one solubility template is selected from a plurality of built solubility templates with which representative model material systems are matched based on a range of solubility, to use the model material system of the selected solubility template as a parameter for predicting a yield.

The processor may be configured, when one particle size distribution template is selected from a plurality of built particle size distribution templates with which representative model material system are matched based on a range of particle size distribution, to use the model material system of the particle size distribution template as a parameter for simulating a population balance equation.

The processor may be configured to: analyze a result of the simulation so that parameters of the templates applied to the crystallization process model are optimized based on the condition for the injection solution and the crystal suspension; and provide analysis data.

The processor may be configured to: change a crystallizer template applied to the crystallization process model to generate a comparative crystallization process model; analyze a result of the simulation performed on the comparative crystallization process model; and recommend an optimal crystallizer based on the condition for the injection liquid and the crystal suspension.

### [Advantageous Effects]

According to the present disclosure, a crystallization model can be easily built and a simulation can be performed, according to the information on the input templates, so even basic researchers can easily perform crystallization process modeling and simulation at low cost.

Additionally, by providing the templates including structural information about crystallization devices used in actual industrial sites, it is possible to simulate an applicable crystallization process that is similar to actual industrial sites without actual case-specific equipment elements and expertise.

### [Description of the Drawings]

FIG. 1 is a configuration view of a crystallization process model generating device according to an exemplary embodiment.
FIG. 2 is a model configuration view for a crystallizer according to an exemplary embodiment.
FIG. 3 is a view showing an example of a crystallizer according to an exemplary embodiment.
FIG. 4 is a flowchart of a method for generating a crystallization process model according to an exemplary embodiment.
FIG. 5 is a flowchart of a crystallizer recommendation method according to an exemplary embodiment.
FIG. 6 is a hardware configuration view of a computing device according to an exemplary embodiment.

### [Mode for Invention]

In the following detailed description, only certain exemplary embodiments of the present disclosure have been shown and described, simply by way of illustration. However, the present disclosure can be variously implemented and is not limited to the following exemplary embodiments. The drawings and description are to be regarded as illustrative in nature and not restrictive. Like reference numerals designate like elements throughout the specification.

In the present disclosure, unless explicitly described to the contrary, the word "comprise", and variations such as "comprises" or "comprising", will be understood to imply the inclusion of stated elements but not the exclusion of any other elements.

The devices described in the present disclosure are composed of hardware including at least one processor, a memory device, a communication device, and the like, and a program that is executed in combination with the hardware is stored in a designated location. The hardware has a configuration and performance that can execute the method of the present disclosure. The program includes instructions that implement the operating method of the present disclosure described with reference to the drawings, and executes the present disclosure in combination with hardware such as a processor and memory device.

In the present disclosure, "transmitting or providing" may include not only direct transmission or provision, but also indirect transmission or provision via another device or using a circuitous route.

In the present disclosure, expressions described in singular can be interpreted as singular or plural unless explicit expressions such as "one" or "single" are used.

In the present disclosure, the same reference numbers refer to the same elements regardless of the drawing, and "and/or" includes each of the mentioned elements and every combination of one or more of the mentioned elements.

In the present disclosure, terms including an ordinary number, such as first and second, are used for describing various constituent elements, but the constituent elements are not limited by the terms. The terms are used only to discriminate one constituent element from another constituent element. For example, a first component may be referred to as a second component, and similarly, a second component may be referred to as a first component without departing from the scope of the present disclosure.

In the flowchart described with reference to the drawings in the present disclosure, the order of the operations may be changed, several operations may be merged, certain operations may be divided, and specific operations may not be performed.

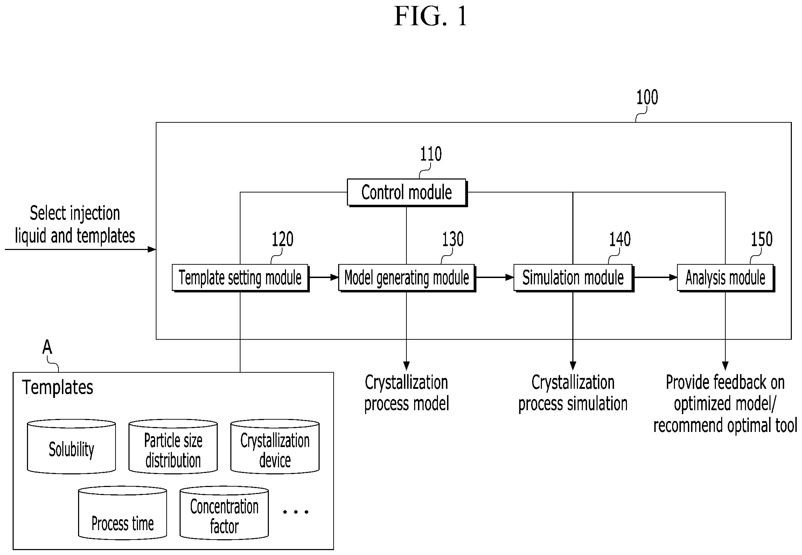

FIG. 1 is a configuration view of a crystallization process model generating device according to an exemplary embodiment.

Referring to FIG. 1, a crystallization process model generating device 100 includes a control module 110, a template setting module 120, a model generating module 130, a simulation module 140, and an analysis module 150.

The control module 110, the template setting module 120, the model generating module 130, the simulation module 140, and the analysis module 150 may be operated by at least one processor. Some modules constituting the crystallization process model generating device 100 may be implemented separately but are described as being integrally implemented for convenience of description. For example, the simulation module 140 executes a crystallization process model generated in the model generating module 130. Since the generated crystallization process model can be linked, the model generating module 130 and the simulation module 140 do not always need to be implemented together.

The control module 110 serves to control operations of each of the template setting module 120, the model generating module 130, the simulation module 140, and the analysis module 150. The control module 110 provides an interface to a user to select one template from a plurality of templates using a check box, a list, a table image, and the like, or to receive an input of a separate parameter, an environmental condition, and the like, and at the same time, can transmit the input values to the template setting module 120, the model generating module 130, and the simulation module 140, respectively.

The template setting module 120 provides one or more preset templates to the user, and receives selection of one of the provided templates. Here, the crystallization process model generating device 100 can individually generate the templates, or search and select one or more templates from a database in which pre-built templates are stored and set parameters of each template. Specifically, a plurality of templates are implemented for a solubility, a particle size distribution, a crystallization device, a process time, a concentration factor ratio, and the like on the basis of certain criteria.

First, the solubility template is built according to criteria accepted in the general crystallization industry, as shown in Table 1 below (J.W. Mullin, Crystallization, 2001).

**(Table 1)**

| Template | General solubility (g/L solution) | Model material system |
|---|---|---|
| Practically insoluble | 0.5 or less | CaCO₃ |
| Slightly soluble | 0.5 to 5 | CaSO₄ |
| Sparingly soluble | 5 to 50 | L-glutamic acid |
| Soluble | 50 to 500 | (NH₄)₂SO₄ |
| Very soluble | 500 or more | Sucrose |

Table 1 shows the criterion (range of solubility) and model material system of the built template. For example, the practically insoluble template represents a template corresponding to CaCO₃ as a representative material among material systems with a solubility value of 0.5 or less. The model material system generally represents, but is not necessarily limited to, a material representative with respect to solubility that is frequently researched, developed, and produced. The model material system can be used in a process of selecting a parameter of a solid-liquid phase equilibrium model for predicting a yield in the crystallization model. The solid-liquid phase equilibrium model is a model for calculating a composition of a mixture solution of a random amount of x solid and a random amount of y liquid when the mixture solution reaches equilibrium. For example, when a stage is divided into a dissolution progress stage (stage 1), a solubility stage (stage 2), a post-solubility stage (stage 3), a dissolution progress stage (stage 4) under different conditions in the post-solubility state, a solidified stage (stage 5) under different conditions in the solubility stage, and the like, an amount of x solid, an amount of y liquid, and conditions (temperature, and the like) for each stage vary, and a composition ratio in the equilibrium state varies accordingly. Accordingly, the solid-liquid phase equilibrium model is included in the solubility template as a model for calculating solubility according to the composition and temperature of the material.

In addition, the model material system is used to determine an initial concentration of the crystallization process. Specifically, when one of the model material systems corresponding to the solubility of the material is selected, it is applied to the solid-liquid phase equilibrium model on the basis of parameters according to the selected material system. A composition ratio in an equilibrium state is accordingly calculated through the solid-liquid phase equilibrium model, so that when the user inputs an amount of material, an amount of water, and a temperature, a composition ratio (initial concentration) in an equilibrium state is determined. For example, solubility parameters, which are parameters of the solid-liquid phase equilibrium model, include a heat of fusion, a melting point, an activity coefficient, and the like.

The particle size distribution template is built according to criteria accepted in the general crystallization industry, as shown in Table 2 below (J.W. Mullin, Crystallization, 2001).

**(Table 2)**

| Template | General average particle size (µm) | Model material system |
|---|---|---|
| Coarse | 700 or greater | (NH4)2SO4 |
| Moderately coarse | 350 to 700 | Glycine |
| Moderately fine | 180 to 350 | Citric acid |
| Fine | 120 to 180 | L-glutamic acid |
| Very fine | 50 to 120 | Phenylalanin |
| Micro fine | 50 or less | CaSO4 |

Table 2 shows the criterion (range of particle size distribution) and model material system of the built template. Here, the model material system generally represents, but is not necessarily limited to, a material representative with respect to particle size that is frequently researched, developed, and produced. The model material system set in the particle size distribution template is used to select parameters of a nucleation rate model and a crystal growth rate model, which are key elements for simulating the population balance equation for predicting particle size distribution. An equation for simulating the nucleation rate and crystal growth rate has a form of a power function, and if simplified, can be expressed as the nucleation rate (B=k_{b}S^{b}) and the crystal growth rate (G=k_{g}S^{g}). K_{b} represents a nucleation rate constant, b represents a nucleation rate order, k_{g} represents a crystal growth rate constant, g represents a crystal growth rate order, and S represents a degree of supersaturation. The nucleation rate and crystal growth rate are determined using the degree of supersaturation calculated through the solid-liquid equilibrium model described above as a driving force. For example, when the nucleation rate is high and the crystal growth rate is low in a state of the same degree of supersaturation, crystal nuclei may be generated quickly, but the growth thereof may not be sufficient, resulting in crystals with a small average particle size. Conversely, when the nucleation rate is low and the crystal growth rate is high, the generated crystal nuclei can grow sufficiently, resulting in crystals with a large average particle size.

Accordingly, by providing the parameters of nucleation rate and crystal growth rate for each general average particle size together with representative model material systems, when a model material system including an average particle size of a material to be calculated is selected, parameters of the model material system are automatically matched and provided. Here, the parameters are values extracted from general crystallization process conditions, the parameters themselves do not mean the average particle size, and the parameters are used to calculate an average particle size of crystals according to a crystallization device, a process time, a concentration factor, and the like determined in templates selected in subsequent steps.

The crystallization device template is built according to currently used crystallization devices such as a mixed suspension mixed product removal (MSMPR) crystallizer, a forced circulation crystallizer, a draft tube baffled (DTB) crystallizer, and an Oslo crystallizer.

Each crystallizer can be fabricated using compartmental modeling techniques through computational fluid dynamics simulation at a previous time. In addition, not only a crystallization compartment required for the crystallization process, but also a sedimentation/flotation compartment, a fine particle dissolution compartment, and an evaporation compartment are also constituted.

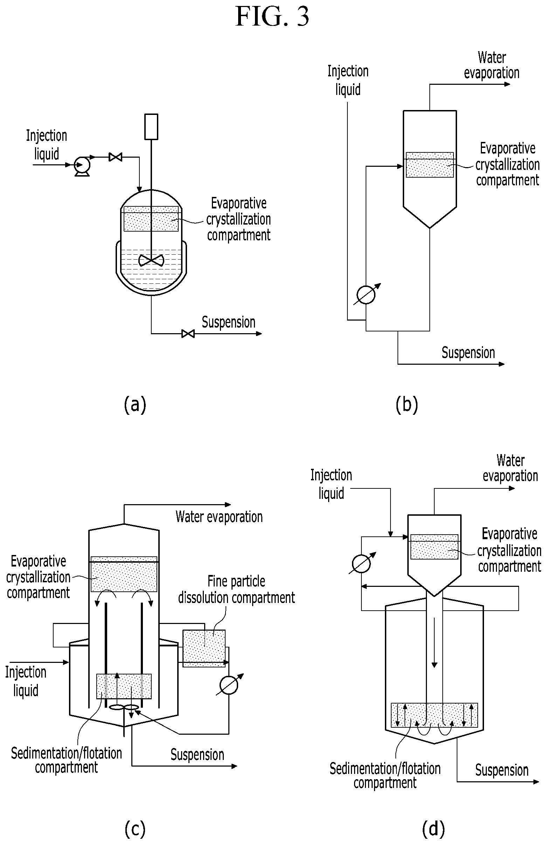

The crystallization device template can be shown as shown in FIG. 3, but is not necessarily limited thereto because a template for a crystallizer can be changed and added.

**(Table 3)**

| Template | Constitutional unit compartment |
|---|---|
| MSMPR crystallizer | evaporative crystallization |
| Forced circulation crystallizer | crystallization, evaporative crystallization |
| DTB crystallizer | crystallization, sedimentation/flotation, fine particle dissolution, evaporative crystallization |
| Oslo Crystallizer | crystallization, sedimentation/flotation, evaporative crystallization |

Table 3 shows the criterion (crystallizer type) and unit compartments constituted accordingly of the built template. The parameters applied in the crystallization device template are an inter-compartment unit flow rate flow, a sedimentation/flotation cutoff size, and the like, and the internal flow is determined through these parameters. Among the crystallizer types (MSMPR, forced circulation crystallizer, DTB crystallizer, Oslo crystallizer), inter-compartment unit flow rate flow can be modified in the DTB crystallizer template and the Oslo crystallizer template, which require inter-compartment discharge distribution. When the DTB crystallizer template and the Oslo crystallizer template are selected, basically, set default values corresponding to each crystallizer are provided, and the inter-compartment unit flow rate flow can be modified in a subsequent process of adjusting detailed conditions.

In addition, when modifying the template itself or adding or directly designing a new crystallizer template, if compartment discharge distribution in the crystallizer is required, the unit flow rate flow for each compartment can be modified separately. For example, the basic principle of the DTB crystallizer is that large crystals are accumulated at the bottom (sedimentation/flotation compartment) by a flow rate generated by a lower impeller and a terminal velocity according to the crystal particle size, and in the process of circulation, fine particles are dissolved and small crystals undergo crystal growth (fine particle dissolution compartment).

At this time, since the inside of the DTB crystallizer is under low pressure, the inside water evaporates at a low temperature, and the corresponding compartment becomes an evaporative crystallization compartment. In addition, a process liquid continuously receives heat from a heat exchanger (not shown) in a circulation line, and the degree of supersaturation generated by the evaporated water becomes the driving force for crystallization.

In the process of moving from the crystallization compartment to the sedimentation/flotation compartment, the unit flow rate should be determined, solids equal to or less than a sedimentation/flotation cutoff size in the sedimentation/flotation compartment move to the fine particle dissolution compartment, and the remaining particles return to the crystallization compartment. Therefore, it is possible to change the sedimentation/flotation cutoff size in the DTB crystallizer template and the Oslo crystallizer template with a sedimentation/flotation compartment.

The crystallization process time template is built based on the process time, as shown in Table 4 below.

**(Table 4)**

| Template | Crystallization process time (hours) |
|---|---|
| Very fast | 0.5 |
| Fast | 2 |
| Moderate | 12 |
| Slow | 24 |
| Very slow | 48 |

The concentration factor template is built based on a constant crystallization concentration factor, as shown in Table 5 below.

**(Table 5)**

| Template | Crystallization concentration factor (fold) |
|---|---|
| Very low | 0.5 |
| Low | 2 |
| Moderate | 4 |
| High | 8 |
| Very high | 16 |

The templates built in this way are each stored in a database in which the parameters are set as default values and linked. The parameters for each template are the same as those in the table previously described, and the inherent parameters are as follows. In other words, the inherent parameters for the solubility template include a heat of fusion, a melting point, an activity coefficient, and the like for each representative material system, and can be modified by the user when modifying detailed conditions.

The inherent parameters of the particle size distribution template are a nucleation rate constant (k_{b}), a nucleation rate order (b), a crystal growth rate constant (k_{g}), a crystal growth rate order (g), and the like of each of the representative material systems, and can be modified by the user when modifying detailed conditions.

The parameters of the crystallization device template are determined for each device selected according to the crystallization device. In particular, in the case of a crystallization device template with compartments that require an inter-compartment discharge distribution, an inter-compartment unit flow rate, a sedimentation/flotation cutoff size, and the like can be modified by the user when modifying detailed conditions.

The parameters of the crystallization process time template and the parameters of the crystallization concentration factor template are the same as Table 4 and Table 5 and can be modified by the user when modifying detailed conditions.

In this way, the template setting module 120 provides a plurality of built templates to the user on the basis of certain steps, and receives selection of one template with respect to each template type. For example, selection of one template is received with respect to each of the solubility template, the particle size distribution template, the crystallization device template, the process time template, and the concentration factor template.

The template setting module 120 may set the parameters set for the selected template differently, based on the input parameters. Here, if an input of a separate parameter value cannot be received, a default value is set. Note that the user may select the model material system, the crystallization device, the crystallization process time, and the crystallization process factor of the template, and modify detailed conditions. If there is no separate parameter modification, the default parameters provided for the template can be used.

When the template setting module 120 receives separately an input of parameters of the selected template from the user, the template setting module 120 changes the solubility parameter for the solubility template, and the solubility template with the changed solubility parameter can be temporarily stored in the database. In other words, the template setting module 120 selects the templates and parameter values selected by the user for application to the crystallization process model and transmits the same to the model generating module 130.

The model generating module 130 generates a crystallization process model, based on the selected templates. The model generating module 130 collects stored model equations based on the selected templates, and finally generates a crystallization process model by using parameters of the determined model equations.

The simulation module 140 simulates a process in which a crystal suspension is derived from an injection liquid set for the built crystallization process model. The simulation module 140 can repeatedly perform the simulation while changing an environmental condition applied to the crystallization process model, and a simulation result can be provided to a linked display device (not shown) or stored in a separate database. Here, the environmental condition represents an injection liquid, an injection liquid concentration, an injection liquid temperature, and the like.

The analysis module 150 provides a crystal recovery rate, a crystal size, and the like, based on information about the crystal suspension derived as a result of the simulation. In addition, the analysis module 150 analyzes the result of the simulation and checks whether the parameters included in the built crystallization process model are optimized. In other words, the analysis module 150 may check whether the crystallization process model generated based on the user's input is optimized and generate and output feedback information.

The analysis module 150 may determine whether or not the optimization, based on the criterion such as a crystal recovery rate (proportion of solid crystals in suspension) and a crystal size. For example, when the crystal recovery rate has the highest value or a value equal to or higher than a reference value as a result of the simulation, the analysis module 150 may estimate that the optimization has been made. Alternatively, when the crystal size has the largest value or a value equal to or higher than a reference value as a result of the simulation, the analysis module 150 may estimate that the optimization has been made. However, the result of crystallization is not necessarily limited to the above because the goal thereof varies depending on situations, and the criteria for determining the optimization can also be easily changed and set later by the user.

Note that the analysis module 150 may use a machine learning model that has completed learning in the process of generating the feedback information based on the input values. For example, the analysis module 150 may use a machine learning model learned to select a crystallizer with the highest crystal recovery rate or largest crystal size based on the input values. Here, the machine learning model can perform reinforcement learning to select an optimal action for a given state.

In addition, the analysis module 150 may use a machine learning model learned to select parameters, types of solubility/particle size distribution/crystallization device/process time/concentration factor templates, and the like that need to be changed in order to satisfy the optimization criteria.

Additionally, the analysis module 150 may request the control module 110 to generate a comparative crystallization process model and to perform a simulation so that an optimized crystallizer can be selected based on the feedback information. In other words, the analysis module 150 can enable generation of comparative crystallization process models by arbitrarily changing the crystallizer template in the generated crystallization process model, thereby analyzing simulation results of a plurality of comparative crystallization process models.

With this, the analysis module 150 can select a crystallization process model with the highest analyzed simulation result and recommend a crystallizer included in the selected crystallization process model. The analysis module 150 may provide only the optimized crystallization process model or selectively provide the most optimized crystallizer according to the result of the comparative analysis, and at the same time, may also provide a result of the comparative analysis performed in order to select the crystallization process model or crystallizer.

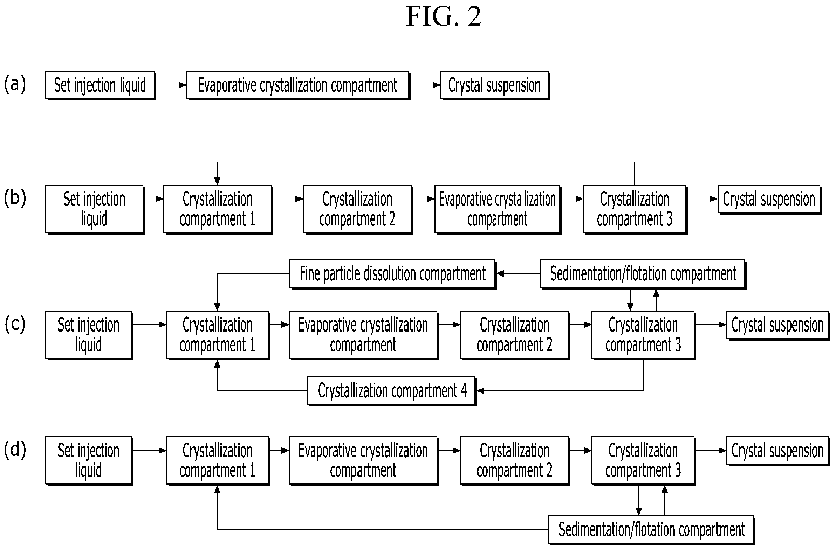

FIG. 2 is a model configuration view for a crystallizer according to an exemplary embodiment, and FIG. 3 is a view showing an example of a crystallizer according to an exemplary embodiment.

In FIG. 2, (a) shows a unit compartment model of a mixed suspension mixed product removal (MSMPR) crystallizer, (b) shows a unit compartment model of a forced circulation crystallizer, (c) shows a unit compartment model of a draft tube baffled (DTB) crystallizer, and (d) shows a unit compartment model of an Oslo crystallizer.

In FIG. 3, (a) is a view simply schematically showing an example of an MSMPR crystallizer, (b) is a view simply schematically showing an example of a forced circulation crystallizer, (c) is a view simply schematically showing an example of a DTB crystallizer, and (d) is a view simply schematically showing an example of an Oslo crystallizer.

Referring to FIGS. 2 and 3, unit compartment models can be compartmented based on equipment characteristics of the four crystallizers. For reference, the distinction by crystallization compartment numbers in FIG. 2 is made for convenience and easy distinction according to flow, and all represent areas for crystallization compartment, regardless of the crystallization compartment numbers.

The MSMPR crystallizer stands for a Mixed-Suspension, Mixed-Product Removal crystallizer, is a theoretical crystallizer and is a crystallizer that mixes a process liquid inside the crystallizer by forcibly circulating the process liquid with an external pump. For example, in the MSMPR crystallizer, an evaporative crystallization (evaporation of water) phenomenon occurs throughout the process liquid, but in the actual process, an evaporation phenomenon occurs based on gas-liquid equilibrium between a surface of an upper part of the process liquid and a gas. An advantage of the MSMPR crystallizer is that it assumes homogeneity, and therefore, allows simple calculation with a theoretical equation, making it easy to calculate a nucleation rate/crystal growth rate. In the MSMPR crystallizer, an injection liquid passes through an evaporative crystallization compartment to derive a crystal suspension.

The forced circulation crystallizer is a crystallizer that mixes a process liquid inside the crystallizer by forcibly circulating the process liquid with an external pump, and has characteristics similar to those of the MSMPR crystallizer when sufficient circulation is made. In the forced circulation crystallizer, evaporation occurs according to the vapor-liquid equilibrium on a process liquid/gas phase surface, and crystallization occurs in the remaining part due to supersaturation caused by evaporation in the evaporative crystallization compartment. In the forced circulation crystallizer, the injection liquid passes through crystallization compartment 1, crystallization compartment 2, evaporative crystallization compartment and crystallization compartment 3 to derive a crystal suspension. At this time, the injection liquid is rerouted to the crystallization compartment 1 from the crystallization compartment 3 and thus can circulate through the crystallization compartment and the evaporative crystallization compartment once again.

In the DTB crystallizer, large crystals are accumulated at the bottom (sedimentation/flotation compartment) and small crystals and fine particles are circulated by a flow rate generated by a lower impeller and a terminal velocity according to the crystal particle size. During the circulation process, fine particles are dissolved and small crystals undergo crystal growth (fine particle dissolution compartment).

In the DTB crystallizer, the crystallization compartments, excluding specific compartments (evaporative crystallization compartment, sedimentation/flotation compartment, and the like) that require inter-compartment discharge distribution, can be expressed as shown in (c) of FIG. 2 when they are temporarily divided according to a process liquid flow through a pre-processed computational fluid dynamics simulation. Therefore, in the DTB crystallizer, the injection liquid passes through crystallization compartment 1, evaporative crystallization compartment, crystallization compartment 2, and crystallization compartment 3 to derive a crystal suspension. At this time, the injection liquid is rerouted to the crystallization compartment 4 from the crystallization compartment 3 and thus can circulate through the crystallization compartment and the evaporative crystallization compartment once again, or is rerouted to the crystallization compartment 4 from fine particle dissolution compartment via sedimentation/flotation compartment and thus can circulate through the crystallization compartment and the evaporative crystallization compartment once again.

In the Oslo crystallizer, the injection liquid is introduced into an evaporator, and flow is formed by a circulation line and a pump connected to an upper part of a crystallizer body. At this time, sedimentation/flotation of crystals occurs due to the differences in flow rate of the formed flow and terminal velocity according to the crystal grain size, and the small crystals floating in the wide crystallizer body slowly stay and undergo crystal growth. Therefore, in the Oslo crystallizer, the injection liquid passes through crystallization compartment 1, evaporative crystallization compartment, crystallization compartment 2, and crystallization compartment 3 to derive a crystal suspension. At this time, the injection liquid is rerouted to the crystallization compartment 1 from the crystallization compartment 3 via sedimentation/flotation compartment and thus can circulate through the crystallization compartment and the evaporative crystallization compartment once again.

Note that the conditions under which the crystal suspension is separated are determined in the concentration factor template, and the concentration factor is (volume of injection liquid/volume of suspension), and in the case of a continuous crystallizer, a volume of the internal process liquid is kept constant only when a balance of (flow rate injected per unit time) = (flow rate discharged per unit time) is formed. Accordingly, when the concentration factor is determined through the template, a volume of the suspension is automatically calculated and a volume of water to be evaporated is determined.

Below, a process of generating a crystallization process model and providing simulation will be described.

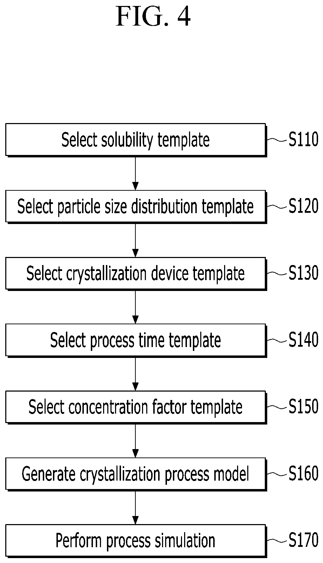

FIG. 4 is a flowchart of a method for generating a crystallization process model according to an exemplary embodiment.

Referring to FIG. 4, the crystallization process model generating device 100 receives selection of one template from the solubility templates (S 110). The crystallization process model generating device 100 may provide a plurality of templates built based on a range of solubility, receive selection of one template, and separately receive an input of a solubility parameter. When the crystallization process model generating device 100 receives selection of one solubility template, the crystallization process model generating device may temporarily store the selected solubility template in a storage location corresponding to a user's unique ID.

The crystallization process model generating device 100 receives selection of one template from the particle size distribution templates (S120). The crystallization process model generating device 100 may provide a plurality of templates built based on a particle size distribution, receive selection of one template, and separately receive an input of a nucleation rate model parameter or crystal growth rate model parameter.

The crystallization process model generating device 100 receives selection of one template from the crystallization device templates (S130). The crystallization process model generating device 100 may provide a plurality of templates built based on the crystallization device, receive selection of one template, and separately receive an input of an inter-compartment unit flow rate flow or sedimentation/flotation cutoff size. At this time, the crystallization process model generating device 100 may separately provide an additional explanation for the crystallization device. For example, an explanation of cases in which each crystallization device is used a lot or what process the device uses to derive a crystal suspension can be provided in text or images.

The crystallization process model generating device 100 receives selection of one template from the process time templates (S140). At this time, the crystallization process model generating device 100 may separately receive an input of conditions for temperature or concentration over time based on the selected template.

The crystallization process model generating device 100 receives selection of one template from the concentration factor templates (S150). At this time, the crystallization process model generating device 100 may separately receive an input of conditions for temperature or concentration over time based on the selected template.

The crystallization process model generating device 100 generates a crystallization process model (S160). The crystallization process model generating device 100 may generate a crystallization process model based on the selected templates and separately input parameters. However, if no parameters are separately input, the default parameters set for each template are input.

The crystallization process model generating device 100 performs simulation of the generated crystallization process model (S170). The crystallization process model generating device 100 performs simulation by applying input environmental conditions to the generated crystallization process model.

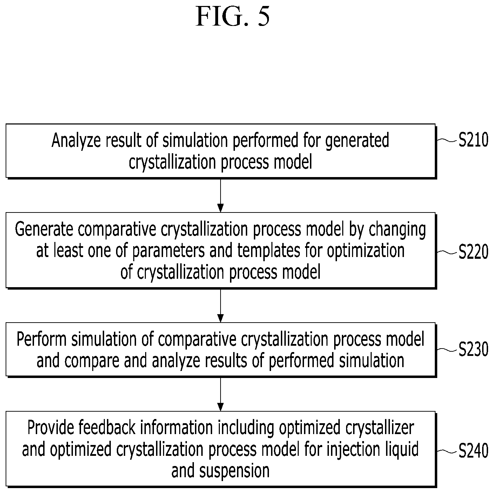

FIG. 5 is a flowchart of a crystallizer recommendation method according to an exemplary embodiment.

Referring to FIG. 5, the crystallization process model generating device 100 analyzes a result of the simulation performed for the generated crystallization process model (S210). The crystallization process model generating device 100 checks whether the generated crystallization process model satisfies the optimization criteria and analyzes the result.

The crystallization process model generating device 100 generates a comparative crystallization process model by changing at least one of the parameters and templates for optimization of the crystallization process model (S220). For example, if the optimization criteria are not satisfied, the crystallization process model generating device 100 selects parameters, types of solubility/particle size distribution/crystallization device/process time/concentration factor templates, and the like that need to be changed in order to satisfy the optimization criteria. Then, the crystallization process model generating device applies the selected change conditions to the crystallization process model to generate a comparative crystallization process model. At this time, a plurality of comparative crystallization process models may be generated by applying the changed conditions individually or in combination.

The crystallization process model generating device 100 performs simulation of the generated comparative crystallization process model and compares and analyzes results of the performed simulation (S230). The crystallization process model generating device 100 compares and analyzes results of the simulation between the comparative crystallization process models along with the generated crystallization process model.

The crystallization process model generating device 100 provides feedback information including an optimized crystallizer and an optimized crystallization process model for the injection liquid and suspension (S240). The crystallization process model generating device 100 may provide only the optimized crystallization process model or selectively provide the most optimized crystallizer according to the comparative analysis result. Here, the feedback information may include the comparative analysis result, in addition to the information about the crystallizer and crystallization process model. In other words, the crystallization process model generating device 100 may provide an analysis result showing the selection of the optimized crystallizer and crystallization process model.

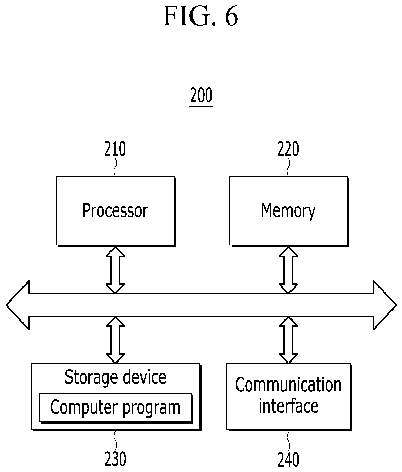

FIG. 6 is a hardware configuration view of a computing device according to an exemplary embodiment.

Referring to FIG. 6, the crystallization process model generating device 100 may be implemented as a computing device 200 operated by at least one processor. The computing device 200 may include one or more processors 210, a memory 220 for loading a computer program executed by the processor 210, a storage device 230 for storing the computer program and various data, a communication interface 240, and a bus connecting the above elements. In addition, the computing device 200 may further include various components.

The processor 210 is a device that controls operations of the computing device 200, may be various types of processors that process instructions included in a computer program, and may include, for example, at least one of a central processing unit (CPU), a microprocessor unit (MPU), a micro controller unit (MCU), a graphic processing unit (GPU), or any type of processor well known in the technical field of the present disclosure.

The memory 220 stores various data, commands and/or information. The memory 220 may load the corresponding computer program from the storage device 230 so that instructions described to execute operations of the present disclosure are processed by the processor 210. The memory 220 may be, for example, a read only memory (ROM), a random access memory (RAM), and the like.

The storage device 230 can non-temporarily store computer programs and various data. The storage device 230 may include a non-volatile memory such as a read only memory (ROM), an erasable programmable ROM (EPROM), an electrically erasable programmable ROM (EEPROM) and a flash memory, a hard disk, a removable disk, or any type of a computer-readable recording medium well known in the technical field to which the present disclosure pertains.

The communication interface 240 may be a wired/wireless communication module that supports wired/wireless communication. The bus provides a communication function among the constitutional elements of the computing device 200.

The computer program includes instructions executed by the processor 210 and are stored on a non-transitory computer readable storage medium, where the instructions cause the processor 210 to execute operations of the present disclosure. The computer program may be downloaded over the network or may be sold in the form of a product. The template may be implemented as a computer program executed by the processor 210.

In this way, according to the exemplary embodiment, a crystallization model can be easily built and a simulation can be performed, according to the information on the input templates, so even basic researchers can easily perform crystallization process modeling and simulation at low cost.

When various parameter values and environmental conditions obtained through theory or experiment are input, the expected crystallization yield and crystal size are automatically calculated, which can help in selecting the actual process in the future.

Additionally, by providing the templates including structural information about crystallization devices used in actual industrial sites, it is possible to simulate an applicable crystallization process that is similar to actual industrial sites without actual case-specific equipment elements and expertise.

The exemplary embodiments of the present disclosure described above can be implemented not only through a device and a method, but also through a program which implements the functions corresponding to the configurations of the exemplary embodiments of the present disclosure or a recording medium on which the program is recorded.

Although the exemplary embodiments of the present disclosure have been described in detail, the scope of the present disclosure is not limited thereto, and various modifications and improvements made by one skilled in the art by using the basic concept of the present disclosure defined in the following claims also fall within the scope of the present disclosure.

## Claims

1. A method for operating a crystallization process model generating device, the method comprising:
receiving selections of a solubility template, a particle size distribution template, a crystallization device template, a process time template, and a concentration factor template provided in a certain order, respectively;
performing modeling of a crystallization process model by combining the selected templates; and
when the crystallization process model is built, receiving an input of a condition for an injection liquid to perform a simulation for deriving a crystal suspension by inputting the injection liquid into the crystallization process model.

2. The method of claim 1, wherein the receiving selections comprises,
when a parameter value different from a default value of a parameter set for the template is input, temporarily storing the template changed with the input parameter value, and
wherein the parameter indicates one or more parameters among a solubility parameter, a nucleation rate model parameter, a crystal growth rate model parameter, an inter-compartment unit flow rate flow, a sedimentation/flotation cutoff size, a temporal temperature and concentration process condition.

3. The method of claim 1, further comprising
building templates for crystallization properties and crystallization process,
wherein the building templates comprises:
dividing constitutional unit compartments based on a geometry of a crystallization device; and
building a plurality of crystallization device templates based on the crystallization device by determining whether the constitutional unit compartments are cycled.

4. The method of claim 3, wherein the building templates comprises
building a plurality of solubility templates with which representative model material systems are matched based on a range of solubility, and
wherein the model material systems of the solubility templates are used as parameters for predicting a yield.

5. The method of claim 3, wherein the building templates comprises
building a plurality of particle size distribution templates with which representative model material systems are matched based on a range of particle size distribution, and
wherein the model material systems of the particle size distribution templates are used as parameters for simulating a population balance equation.

6. The method of claim 1, further comprising:
analyzing a result of the simulation so that parameters of the templates applied to the crystallization process model are optimized based on the condition for the injection solution and the crystal suspension; and
providing analysis data.

7. A computing device comprising:
a memory comprising instructions; and
at least one processor configured to generate a crystallization process model by executing the instructions,
wherein the processor is configured to:
receive selections of one or more templates of a crystallization property template and a process template provided in a certain order; and
perform modeling of a crystallization process model by combining the selected templates.

8. The computing device of claim 7, wherein the processor is configured to:
receive selections of a solubility template, a particle size distribution template, a crystallization device template, a process time template, and a concentration factor template provided in a certain order, respectively;
when a parameter for a specific template is input, temporarily store a template to which the input parameter is applied; and
when no parameter is input, temporarily store a template to which default values for the template is applied.

9. The computing device of claim 7, wherein the processor is configured to
receive one or more parameters among a solubility parameter, a nucleation rate model parameter, a crystal growth rate model parameter, an inter-compartment unit flow rate flow, a sedimentation/flotation cutoff size, a temporal temperature and concentration process condition.

10. The computing device of claim 7, wherein the processor is configured to:
when the crystallization process model is built, receive an input of a condition for an injection liquid; and
perform a simulation for deriving a crystal suspension by inputting the injection liquid into a crystallization process model.

11. The computing device of claim 7, wherein the processor is configured,
when one solubility template is selected from a plurality of built solubility templates with which representative model material systems are matched based on a range of solubility,
to use the model material system of the selected solubility template as a parameter for predicting a yield.

12. The computing device of claim 7, wherein the processor is configured,
when one particle size distribution template is selected from a plurality of built particle size distribution templates with which representative model material system are matched based on a range of particle size distribution,
to use the model material system of the particle size distribution template as a parameter for simulating a population balance equation.

13. The computing device of claim 7, wherein the processor is configured to:
analyze a result of the simulation so that parameters of the templates applied to the crystallization process model are optimized based on the condition for the injection solution and the crystal suspension; and
provide analysis data.

14. The computing device of claim 7, wherein the processor is configured to:
change a crystallizer template applied to the crystallization process model to generate a comparative crystallization process model;
analyze a result of the simulation performed on the comparative crystallization process model; and
recommend an optimal crystallizer based on the condition for the injection liquid and the crystal suspension.
